# EUROPÄISCHE PATENTSCHRIFT

(11) **EP 2 204 657 B1**
(45) Veröffentlichungstag und Bekanntmachung des Hinweises auf die Patenterteilung: **25.07.2018**
(21) Anmeldenummer: 09180569.7
(22) Anmeldetag: 23.12.2009
(51) Int. Cl.: G01R 1/36, G01R 15/12

(54) **MULTIMETER MIT ELEKTRONISCHEM ÜBERSTROMSCHUTZ**
MULTIMETER WITH ELECTRONIC EXCESS CURRENT PROTECTION
MULTIMÈTRE DOTÉ D'UNE PROTECTION ÉLECTRONIQUE CONTRE LES SURINTENSITÉS

(30) Priorität: 30.12.2008 AT 75908 U
(43) Veröffentlichungstag der Anmeldung: 07.07.2010
(73) Patentinhaber: AVL DiTest GmbH, 8020 Graz (AT)
(72) Erfinder: Mantsch, Peter, 8010, Graz (AT); Krammer, Gerald, 8010, Graz (AT)
(74) Vertreter: Patentanwälte Pinter & Weiss OG

(56) Entgegenhaltungen:
- US-A- 4 344 101
- US-A1- 2004 130 330

## Beschreibung

Die Erfindung, welche durch die Merkmale des Anspruchs 1 definiert ist, betrifft ein Multimeter,, mit elektronischem Überstromschutz, dessen Messkreise für Strom, Spannung und Widerstand wahlweise mit den beiden Messspitzen elektrisch verbunden werden können, wobei ein elektrisch zu betätigender Mechanismus zur Unterbrechung des Stromkreises bei einer Überstromsituation vorgesehen ist.

Bei derartigen Messgeräten ist für die Strommessung ein geringer Eingangswiderstand erforderlich, typischerweise in der Größenordnung von 0. 1Ω, der bereits bei Anlegen einer kleinen Spannung an die Messleitungen einen beträchtlichen Stromfluss ermöglicht. Damit die Bauteile des Strommesskreises im Fall einer Überstromsituation keinen Schaden nehmen, ist es erforderlich eine solche Situation mit Hilfe einer Stromüberwachung zu erkennen und den Messkreis hinreichend rasch zu unterbrechen.

Ein Relais mit hinreichender Strombelastbarkeit sorgt für die notwendige Spannungsfestigkeit, wobei das Relais mit bis zu 1 kV beaufschlagt werden kann. Das Relais mit seiner Einschaltzeit von ca. 6 ms und seiner Ausschaltzeit von ca. 3 ms ist aber nicht in der Lage im Fall eines schnell ansteigenden Stromes nach Erkennen der Überstromsituation den Messkreis schnell genug zu unterbrechen.

In der CN 101295591 A, der CN 201041776 Y und der JP 3210716 A ist die Kombination eines mechanischen Schalters (in Form eines Relais) und eines kontaktlosen Schalter (MOS-Relais) in Serienschaltung beschrieben, um einen Lichtbogen während des Schaltvorganges zu vermeiden bzw. die Aussendung elektrischer Störungen (Noise), welche bei Ein- und Ausschalten eines herkömmlichen mechanischen Relais entstehen, zu vermeiden. Zusätzlich sehen die CN 101295591 A sowie die CN 201041776 Y parallel zur Serienanordnung ein Relais vor, das geschlossen wird, um höhere elektrische Lasten zu bewältigen. Die US 4,344,101 A offenbart einen Überstromschutz unter Verwendung von Relais und NPN-Bipolartransistoren.

Die KR100340970 verwendet eine Kette aus Strommessung, Spannungs-Strom-Wandler und Komparatorschaltung, um eine Überstromabschaltung über eine Opto-MOS-Strecke auszulösen. Der OptoMOS wird verwendet, um zwischen jenem Schaltungsteil, der die Überstromsituation erkennt, und jenem Schaltungsteil, der den Stromkreis unterbricht eine Potentialtrennung zu erzeugen. Der Laststrom bzw. Messstrom fließt jedoch nicht über den OptoMOS.

In der DE 19738989 A1 ist die Verwendung eines Relais zum Schalten einer Last beschrieben. Eine Stromüberwachung in Form eines Messwiderstandes in Reihe zum mechanischen Schalter mit nachfolgendem Komparator dient zum Erkennen eines Überstromes, welcher das Schalten eines Halbleiterschalters bewirkt, welcher wiederum das Relais ausschaltet, damit das Relais selbst und der Verbraucher keinen Schaden nehmen. Diese Art der Abschaltung über ein mechanisches Relais ist sehr langsam, da erst der Halbleiterschalter schaltet, sich danach ein Strom durch die Steuerspule aufbauen muss und schließlich der mechanische Schalter bewegt werden muss.

Die Aufgabe der vorliegenden Erfindung ist daher eine Schaltungsanordnung, mit welcher eine schnelle automatische Unterbrechung des Stromkreises bei Erkennen einer Überstromsituation gewährleistet wird, wobei sowohl eine hinreichende Strombelastbarkeit in geschlossenem Schaltzustand als auch eine ausreichende Spannungsfestigkeit in geöffnetem Zustand gewährleistet sein sollen.

Zur Lösung dieser Aufgabe ist das erfindungsgemäße Multimeter so ausgestaltet, dass ein mechanisches Relais, ein schnell schaltendes Solid State Relais, eine Induktivität zur Verlangsamung eines Stromanstiegs, und ein Messwiderstand in Serie geschaltet sind. Ein Solid State Relais als schnelles Schaltelement kann den Stromkreis in kurzer Zeit unterbrechen, typischerweise mit Ausschaltzeiten von ca. 0.1 bis 0.2 ms. Die Spannungsfestigkeit ist über das mechanische Relais gewährleistet. Gleichzeitig verlangsamt eine Induktivität in Serie zu den Schaltern den Stromanstieg, so dass der Strom von Erkennen der Überstromsituation bis zum Abschalten des Stromkreises kein zerstörerisches Ausmaß annehmen kann.

Gemäß einer vorteilhaften Ausführungsform der Erfindung ist das Solid State Relais als OptoMOS Transistor in nur einer Schaltungskomponente ausgeführt. Der OptoMOS Transistor ist im Gegensatz zum MOS-Transistor mit parasitärer Body-Diode in der Lage den Stromkreis sowohl in positiver als auch in negativer Stromrichtung wesentlich schneller als mechanische Relais zu unterbrechen.

Vorteilhafterweise sind schnelle Spannungskomparatoren zum Vergleich des Spannungsabfalls am Messwiderstand mit vorgegebenen Schwellwerten vorgesehen.

In der nachfolgenden Beschreibung soll die Erfindung anhand eines konkreten Ausführungsbeispiels näher erläutert werden.

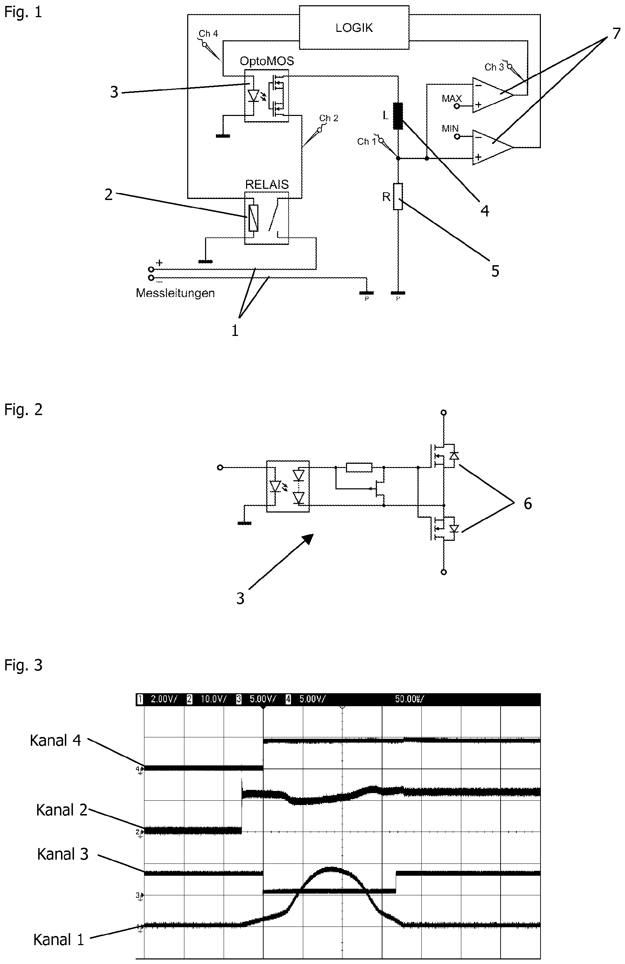

Fig. 1 ist ein Schaltbild eines erfindungsgemäßen Multimeters, Fig. 2 eine Schaltungsvariante des Solid State Relais alternativ zum OptoMOS und Fig. 3 zeigt die Stromund Spannungsverläufe im Fall einer Überstromsituation in Form eines schnell ansteigenden Stromes hervorgerufen durch Anlegen eines Spannungssprungs an die Messspitzen.

Das erfindungsgemäße Multimeter mit Schaltplan wie in Fig. 1 verfügt über zwei Messleitungen 1, die zur Messung von elektrischer Spannung, elektrischen Strom und ohmschen Widerstand verwendet werden. Die Messkreise für Strom, Spannung und Widerstand können dabei wahlweise mit den beiden Messspitzen elektrisch verbunden werden.

In Serie mit der positiven Prüfspitze ist das mechanische Relais 2, dann ein Solid State Relais 3 in Form eines OptoMOS Transistors, gefolgt von einer Induktivität 4 und dem eigentlichen Messwiderstand 5. Es sind somit zwei Bauelemente, nämlich das Relais 2 und der OptoMOS Transistor 3 vorgesehen, die den Stromkreis unterbrechen können.

Der zum Relais 2 in Serie liegende OptoMOS Transistor 3 kann den Stromkreis in kurzer Zeit unterbrechen, typischerweise mit Ausschaltzeiten von ca. 0,1 bis 0,2 ms, ist aber nicht in der Lage der maximal zulässigen Eingangsspannung, welche der Modus Spannungsmessung erfordert, standzuhalten. Das Solid State Relais 3 kann im Gegensatz zu einem einzelnen MOS-Transistor mit parasitärer Body-Diode den Stromkreis sowohl in positiver als auch in negativer Stromrichtung unterbrechen.

Alternativ zur Einkomponenten-Lösung kann, wie in Fig. 2 dargestellt ist, das Solid State Relais auch mit zwei MOS-Transistoren 6 mit optisch isolierten Gate-Treibern realisiert werden, wobei die Transistoren 6 in Serie geschaltet sind, so dass ihre Body-Dioden antiparallel zueinander liegen. Durch diese Ausgestaltung des Solid State Relais 3 kann die Ausschaltzeit noch weiter verbessert werden.

Steigt der Messstrom langsam und kontinuierlich an ist eine zuverlässige Überstromerkennung jedenfalls gegeben. Steigt der Strom sprunghaft an, wenn z.B. das Multimeter sich im Strommessmodus befindet, die Messspitzen erst offen sind, und dann an eine Messspannung gelegt werden, steigt auch der Strom, der durch den Messkreis fließt sehr schnell an.

Trotz der geringen Ausschaltzeit des Solid State Relais 3 kann in der Zeit vom Erkennen des Überstromes bis zum Abschalten des Transistors 3 bzw. der Transistoren 6 ein erheblicher Stromfluss zustande kommen.

Die Induktivität 4 in Serie zum Messwiderstand 5 verlangsamt den Anstieg des Stromes bei Anlegen einer Spannung. Aufgrund dieser Verlangsamung ist das Solid State Relais 3 in der Lage den Stromfluss rechtzeitig zu unterbrechen, bevor Bauteile des Strompfades thermischen Schaden nehmen.

Die Erkennung eines Überstromes erfolgt über gewöhnliche schnelle Spannungskomparatoren 7, welche den Spannungsabfall über den Messwiderstand mit vorgegebenen Schwellwerten (MAX und MIN im Schaltbild) vergleichen.

Fig. 3 zeigt den Stromverlauf in Kanal 1, den Ausgang der Stromüberwachungsschaltung in Kanal 3 (0=Überstrom, 1=kein Überstrom), das Schaltsignal für die Stromabschaltung in Kanal 4 (0=ein, 1=aus) und die von außen angelegte Spannung in Kanal 2 (Messpunkt nach dem mechanischen Relais). Für eine rechtzeitige Abschaltung reicht das mechanische Relais aufgrund seiner Ausschaltverzögerung alleine nicht aus.

Wie in Fig. 3 deutlich zu erkennen ist, zeigt der flache Teil des Anstiegs von Kanal 1, dass die Induktivität 4 den Stromanstieg merklich bremst und so die Überstromerkennung (Kanal 3) und das Solid State Relais 3 (Kanal 4) den Stromfluss rechtzeitig unterbrechen können. Der folgende, etwas steilere Anstieg des Stromes ist darauf zurückzuführen, dass die Induktivität 4 in Sättigung gerät und der Strom in Folge, nur durch die Leitungsinduktivität gebremst, weiter ansteigt. Zu diesem Zeitpunkt ist die Abschaltung des Solid State Relais 3 bereits eingeleitet, was eine Abnahme des Stromes und schließlich eine Unterbrechung des Stromkreises nach sich zieht. Die Schaltung nach Fig. 1 gewährleistet also die automatische und durch den Transistor 3 sehr schnelle Unterbrechung des Stromkreises bei Erkennen einer Überstromsituation, wobei gleichzeitig durch das Relais 2 im abgeschalteten Zustand eine hohe Spannungsfestigkeit gegeben ist.

## Patentansprüche

1. Multimeter, mit elektronischem Überstromschutz, dessen Messkreise für Strom, Spannung und Widerstand wahlweise mit den beiden Messspitzen (1) elektrisch verbunden werden können, wobei ein elektrisch zu betätigender Mechanismus (2, 3) zur Unterbrechung des Stromkreises bei einer Überstromsituation vorgesehen ist, wobei ein schnell schaltendes Solid State Relais (3) und ein mechanisches Relais (2) als elektrisch zu betätigende Mechanismen (2, 3) sowie eine Induktivität (4) zur Verlangsamung eines Stromanstiegs und ein Messwiderstand (5) alle in Serie geschaltet sind.

2. Multimeter nach Anspruch 1, **dadurch gekennzeichnet, dass** als Solid State Relais (3) ein OptoMOS Transistor vorgesehen ist.

3. Multimeter nach Anspruch 1 oder 2, **dadurch gekennzeichnet, dass** schnelle Spannungskomparatoren (7) zum Vergleich des Spannungsabfalls am Messwiderstand (5) mit vorgegebenen Schwellwerten vorgesehen sind.

## Claims

1. Multimeter with electronic overcurrent protection, the measuring circuits of which for current, voltage and resistance can optionally be electrically connected to the two probe tips (1), wherein an electrically actuable mechanism (2, 3) is provided for interrupting the electric circuit in the event of overcurrent, wherein a fast-switching solid state relay (3) and a mechanical relay (2), as the electrically actuable mechanisms (2, 3), and an inductor (4) for decelerating a current increase, and a measuring resistor (5), are all connected in series.

2. Multimeter according to claim 1, **characterized in that** an OptoMOS transistor is provided as the solid state relay (3).

3. Multimeter according to either claim 1 or claim 2, **characterized in that** fast voltage comparators (7) are provided for comparing the voltage drop at the measuring resistor (5) with predetermined threshold values.

## Revendications

1. Multimètre, comprenant une protection électronique contre les surintensités, dont les circuits de mesure du courant, de la tension et de la résistance peuvent être connectés électriquement aux deux pointes de mesure (1), un mécanisme à actionnement électrique (2, 3) étant prévu pour interrompre le circuit dans une situation de surintensité, un relais à semiconducteur à commutation rapide (3) et un relais mécanique (2) comme mécanismes à actionnement électrique (2, 3) ainsi qu'une inductance (4) destinée à ralentir une augmentation de courant et une résistance de mesure (5) étant tous connectés en série.

2. Multimètre selon la revendication 1, **caractérisé en ce qu'**un transistor OptoMOS est prévu comme relais à semi-conducteurs (3).

3. Multimètre selon la revendication 1 ou 2, **caractérisé en ce que** des comparateurs de tension rapides (7) sont prévus pour comparer la chute de tension aux bornes de la résistance de mesure (5) avec des valeurs de seuil prédéterminées.
